# EUROPEAN PATENT APPLICATION

(11) **EP 2 455 990 A2**
(43) Date of publication of application: **23.05.2012**
(21) Application number: 11190129.4
(22) Date of filing: 22.11.2011
(51) Int. Cl.: H01L 33/56, H01L 33/60, H01L 33/48, H01L 33/50

(54) **LED package**

(30) Priority: 22.11.2010 JP 2010259936
(71) Applicant: Panasonic Electric Works Co., Ltd., Kadoma-shi Osaka 571-8686 (JP)
(72) Inventor: Kanai, Norio, Hirakata, Osaka (JP); Kuzuhara, Ikko, Toyonaka, Osaka (JP)
(74) Representative: Rüger, Barthelt & Abel

(57) **Abstract**

An LED light-emitting device (10) that can increase a light output with ease and low costs includes: at least one LED chip (11); a casing (12) having the LED chip (11) mounted thereon; and two or more kinds of translucent members (13,14) which are set in the casing (12) and which have different refraction indexes, wherein light radiated from the LED chip (11) to the casing (12) is reflected on a border surface (18) between the translucent members (13,14).

## Description

### [Field of the Invention]

The present invention relates to an LED light-emitting device using an LED chip.

### [Background Art]

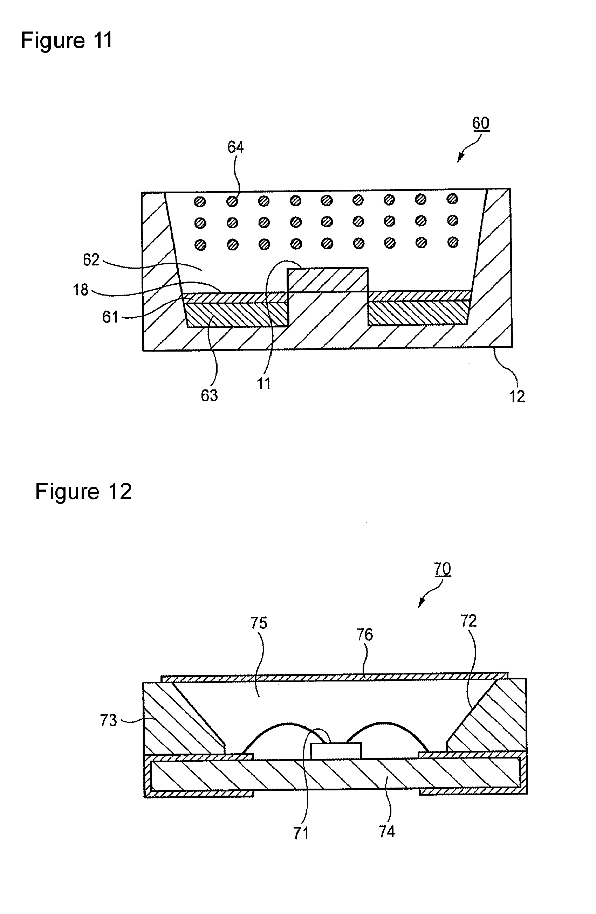

Conventionally known is, as shown in Fig. 12, an LED light-emitting device 70 including: a light reflection member 73 surrounding the surroundings of an LED chip 71 in a manner such as to form a storage part 72 storing the LED chip 71; a sealing resin layer 75 provided at the storage part 72 to seal the LED chip 71 mounted on a substrate 74; and a phosphorous member 76 of synthetic resin which has a phosphor and which is attached to a front surface of the sealing resin layer 75 (for example, see Patent Literature 1).

Also conventionally known is an LED light-emitting device having resist (white resist) applied to a mounting surface of an LED chip (for example, see Patent Literature 2).

Further conventionally known is an LED light-emitting device having silvery-white metal plating provided on a mounting surface of an LED chip (for example, see Patent Literature 3).

### [Conventional Technique Document]

### [Patent Literature]

[Patent Literature 1] JPA 2007-220737 (Fig. 1 and claim 1)
[Patent Literature 2] JPA 2007-324205 (Fig. 3 and claim 1)
[Patent Literature 3] JPA 2007-189006 (Fig. 4 and claim 1)

### [Disclosure of the Invention]

### [Problems to be solved by the Invention]

An LED light-emitting device using an LED chip is small-sized and easy-to-use, and thus used for various applications. In recent years, the LED light-emitting device has dramatically increased a light output and is thereby frequently used for illumination purposes.
Such an LED light-emitting device increases the light output by using a plurality of relatively small light-emitting elements of, for example, approximately 0.3-mm cube, and increases the light output by flowing a large current to a relatively large light-emitting element of, for example, approximately 1.0-mm cube.
Further, such an LED light-emitting device is required to efficiently take out light radiated from the LED chip for the purpose of achieving a higher output.

The LED light-emitting device 70 described in Patent Literature 1 has been suggested to solve such a problem, and chromaticity variation is small and thus chromaticity is stable without deteriorating efficiency in taking out light emitted from the LED chip 71.
However, in the LED light-emitting device 70 described in Patent Literature 1, a light component from the LED chip 71 directly hitting the substrate 74 is absorbed by the substrate 74.
Therefore, the LED light-emitting device 70 described in Patent Literature 1 faces deteriorated efficiency since the light component from the LED chip 71 directly hitting the substrate 74 is absorbed by the substrate 74.

On one hand, the LED light-emitting device described in Patent Literature 2 reflects, by the white resist on the mounting surface of the LED chip, a light component emitted from the LED chip towards the mounting surface of the LED chip to take out the light.
On the other hand, the LED light-emitting device described in Patent Literature 3 improves a reflection ratio by the silvery-white metal plating on the mounting surface of the LED chip.

However, the LED light-emitting device described in Patent Literature 2 and the LED light-emitting device described in Patent Literature 3 have difficulty in machined for setting a reflection raw material. Moreover, their high reflection raw materials easily encounter aging deterioration. Silver in particular experiences dramatic deterioration in the reflection ratio following sulfurization, and have a reflection ratio of approximately 90%, which is poor in efficiency.
Therefore, the LED light-emitting device described in Patent Literature 2 and the LED light-emitting device described in Patent Literature 3 cannot increase light output with ease and low costs.

In view of the problem described above, the present invention has been made, and it is an object of the present invention to provide an LED light-emitting device that can increase a light output with ease and low costs.

### [Means adapted to solve the Problems]

An LED light-emitting device according to the present invention includes: at least one LED chip; a casing having the LED chip mounted thereon; and two or more kinds of translucent members which are set in the casing and which have different refraction indexes, wherein light radiated from the LED chip to the casing is reflected on a border surface between the translucent members.

In the LED light-emitting device according to the present invention, light exiting from a wall surface of the LED chip towards a mounting surface of the LED chip is reflected on the border surface between the translucent members.

In the LED light-emitting device according to the present invention, the light exiting from the wall surface of the LED chip towards the mounting surface of the LED chip has an angle of incidence on the border surface between the translucent members equal to or larger than a critical angle.

In the LED light-emitting device according to the present invention, the translucent members include: the first translucent member set on a front surface of the casing; and the second translucent member which has the refraction index higher than the refraction index of the first translucent member and which is set on a top surface of the first translucent member, and the light from the LED chip is reflected on the border surface between the first translucent member and the second translucent member.

In the LED light-emitting device according to the present invention, the LED chip is molded with the translucent member.

In the LED light-emitting device according to the present invention, the refraction index of the translucent member is equal to a refraction index of the LED chip.

In the LED light-emitting device according to the present invention, a high reflection member is set between the translucent member and the casing.

In the LED light-emitting device according to the present invention, the translucent member is of glass.

In the LED light-emitting device according to the present invention, the high reflection member is applied to the glass subjected to mirror finishing and set in the casing.

In the LED light-emitting device according to the present invention, silver is applied to the glass and a high reflection member obtained by coating silver with a protective film is used.

In the LED light-emitting device according to the present invention, at least either of titanium and tungsten is used for the protective film.

In the LED light-emitting device according to the present invention, a gap is provided at a front surface of the casing at surroundings of the LED chip, and the high reflection member is set in the gap.

In the LED light-emitting device according to the present invention, a high heat resisting member of 1W/mK or below is set between the high reflection member and the casing.

In the LED light-emitting device according to the present invention, a translucent member having a refraction index larger than 1 and smaller than the refraction index of the translucent member is set above the translucent member.

In the LED light-emitting device according to the present invention, the translucent member has a phosphor which is excited by the light exiting from the LED chip and which emits light of a wavelength different from a wavelength of the light exiting from the LED chip.

In the LED light-emitting device according to the present invention, a member used for the translucent member has a characteristic such that light transmittance in a thickness of 2 mm is 85% or above in a wavelength range of 400 nm to 860 nm.

In the LED light-emitting device according to the present invention, the LED chip emits a blue light.

### [Effect of the Invention]

An LED light-emitting device according to the present invention provides effect such that a light output can be increased with ease and low costs.

### [Brief Description of the Drawings]

[Fig. 1] Fig. 1 is a vertical sectional view of an LED light-emitting device according to a first embodiment of the present invention.
[Fig. 2] Fig. 2 is a vertical sectional view of a method of manufacturing the LED light-emitting device according to the first embodiment of the present invention.
[Fig. 3] Fig. 3 is a vertical sectional view of the method of manufacturing the LED light-emitting device according to the first embodiment of the present invention.
[Fig. 4] Fig. 4 is a vertical sectional view of a wiring pattern of the LED light-emitting device according to the first embodiment of the present invention.
[Fig. 5] Fig. 5 is a vertical sectional view of an LED light-emitting device according to a second embodiment of the present invention.
[Fig. 6] Fig. 6 is a vertical sectional view of a modified example of the LED light-emitting device according to the second embodiment of the present invention;
[Fig. 7] Fig. 7 is a vertical sectional view an LED light-emitting device provided with a gap according to a third embodiment of the present invention.
[Fig. 8] Fig. 8 is a vertical sectional view of a modified example of the LED light-emitting device according to the third embodiment of the present invention.
[Fig. 9] Fig. 9 is a vertical sectional view of an LED light-emitting device according to a fourth embodiment of the present invention.
[Fig. 10] Fig. 10 is a vertical sectional view of an LED light-emitting device according to a fifth embodiment of the present invention.
[Fig. 11] Fig. 11 is a vertical sectional view of an LED light-emitting device according to a sixth embodiment of the present invention.
[Fig. 12] Fig. 12 is a vertical sectional view of a conventional LED light-emitting device.

### [Best Mode for Carrying Out the Invention]

Hereinafter, LED light-emitting devices according to a plurality of embodiments of the present invention will be described referring to the drawings.

### (First Embodiment)

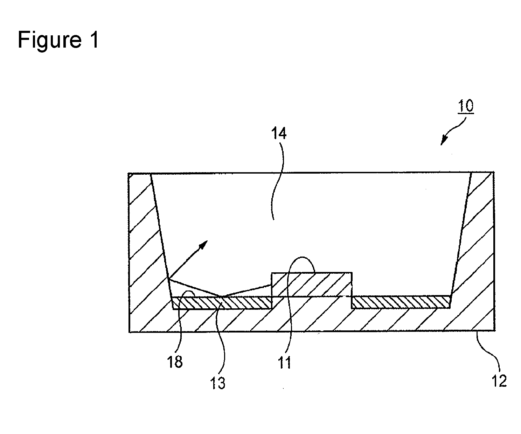

As shown in Fig. 1, the LED light-emitting device 10 according to the first embodiment of the present invention includes: at least one LED chip 11; a casing 12 on which the LED chip 11 is mounted; and a first translucent member 13 and a second translucent member 14 which are set in the casing 12 and which have different refraction indexes. The LED light-emitting device 10 has a wiring pattern and wire bonding, both not shown.

The LED chip 11 is a blue LED that emits a blue light.
Therefore, the LED chip 11 is easily accessible and can be manufactured with cost advantages.

The casing 12 has the LED chip 11 mounted at a bottom central part.
Members used for the first translucent member 13 and the second translucent member 14 have an optical characteristic such that light transmittance in a thickness of 2 mm is 85% or above in a wavelength range of 400 nm to 860 nm.
Therefore, since the members used for the first translucent member 13 and the second translucent member 14 have the optical characteristic such that the light transmittance in the thickness of 2 mm is 85% or above in the wavelength range of 400 nm to 860 nm, they are easily manufactured and can also be manufactured with cost advantages.

The first translucent member 13 has a smaller refraction index than that of the second translucent member 14. The second translucent member 14 has the same refraction index as the LED chip 11.
Therefore, since_the second translucent member 14 has the same refraction index as the LED chip 11, light from the LED chip 11 can be used efficiently.

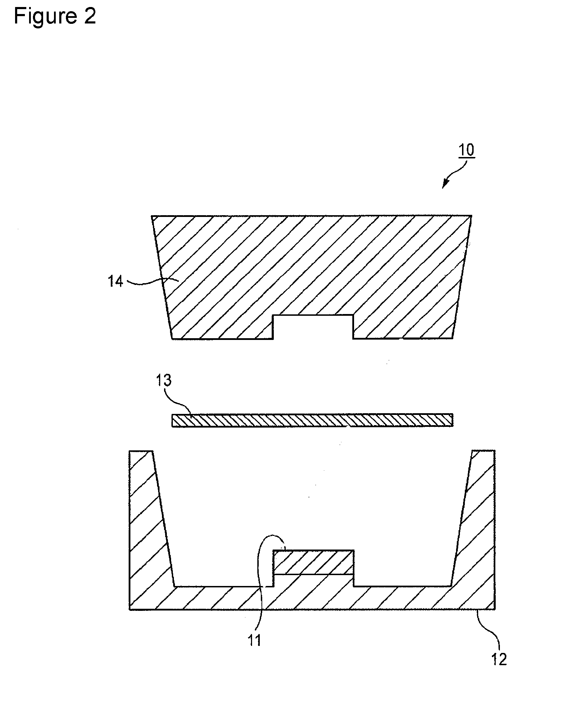

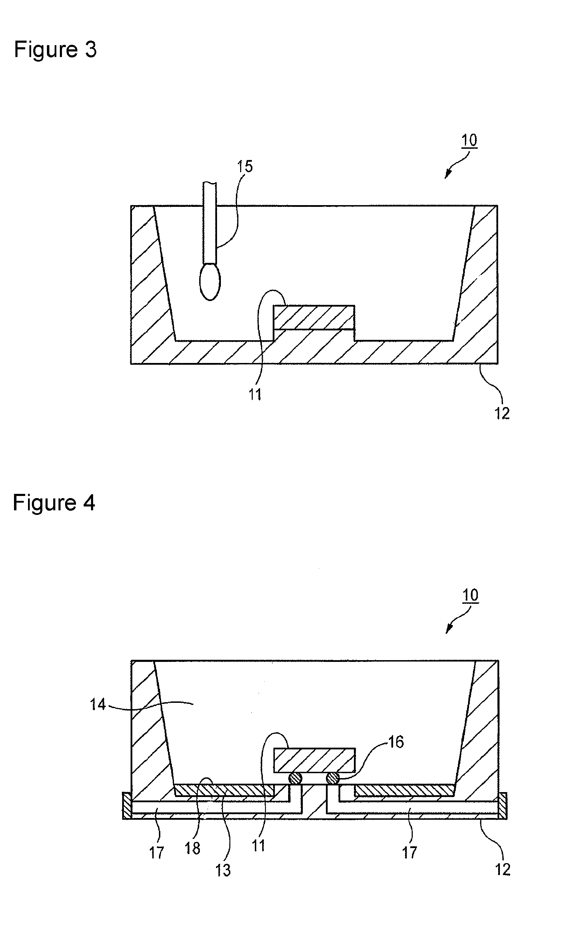

As shown in Fig. 2, upon the manufacture of the LED light-emitting device 10, the first translucent member 13 and the second translucent member 14 are previously formed into predetermined shapes and inserted inside the casing 12.
As shown in Fig. 3, instead of the manufacturing method shown in Fig. 2, for the LED light-emitting device 10, it is also possible to apply the first translucent member 13 and the second translucent member 14 from a nozzle 15.
Note that in the method of manufacturing the LED light-emitting device 10, FIGS. 2 and 3 may be combined together as appropriate.
Therefore, the LED chip 11 is molded with the first translucent member 13 and the second translucent member 14 and thus firmly fixed without any dislocation.

As shown in Fig. 4, the LED light-emitting device 10 is, as a result of mounting the LED chip 11 onto the casing 12 with bumps 16 in between, electrically connected to a wiring pattern 17. The wiring pattern 17 is pulled out of the casing 12 to form an electrode.
Note that the wire bonding, not shown, may be used without using the wiring pattern 17.

Returning back to Fig. 1, upon light emission by the LED chip 11 as a result of power feed, a light component exiting from a wall surface of the LED chip 11 to a mounting surface is guided into the first translucent member 13 and then enters into the second translucent member 14. At this point, the light component whose angle of incidence exceeds a critical angle is totally reflected on a border surface 18 between the first translucent member 13 and the second translucent member 14.
Therefore, since the light exiting from the LED chip 11 towards the casing 12 is reflected on the border surface 18 between the first translucent member 13 and the second translucent member 14 which have the different refraction indexes, reducing light absorbed by the casing 12 can increase light output with an extremely simple, low-cost structure without considering, for example, a material of the casing 12.

Here, a height of the border surface 18 between the first translucent member 13 and the second translucent member 14 can be adjusted.
Therefore, a ratio in which the light component exiting from the wall surface of the LED chip 11 towards the mounting surface and then entering into the first translucent member 13 exceeds the critical angle can be increased to thereby increase light efficiency.

The LED light-emitting device 10 reflects, on the border surface 18 between the first translucent member 13 and the second translucent member 14, the light component exiting from the wall surface of the LED chip 11 towards the mounting surface.
Therefore, the light component reliably enters from the first translucent member 13 into the second translucent member 14, and reducing the light absorbed by the casing 12 can increase the light output.

For the LED light-emitting device 10, in the light component exiting from the wall surface of the LED chip 11 towards the mounting surface, the angle of incidence on the border surface 18 between the first translucent member 13 and the second translucent member 14 is equal to or larger than the critical angle.
Therefore, the total reflection of the light component on the border surface 18 can reduce the light absorbed by the casing 12 and increase the light output.

The LED light-emitting device 10 includes: the first translucent member 13 set on a front surface of the casing 12; and the second translucent member 14 which has the higher refraction index than that of the first translucent member 13 and which is set on the top surface of the first translucent member 13, and on the border surface 18 between the first translucent member 13 and the second translucent member 14, the light component from the LED chip 11 is reflected.
Therefore, the light component exiting from the wall surface of the LED chip 11 towards the mounting surface enters from the second translucent member 14 into the first translucent member 13, and thus reducing the light absorbed by the casing 12 can increase the light output.

As described above, according to the LED light-emitting device 10 of the first embodiment, the light exiting from the LED chip 11 towards the casing 12 is reflected on the border surface 18 between the first translucent member 13 and the second translucent member 14 which have the different refraction indexes; therefore, reducing the light absorbed by the casing 12 can increase the light output with an extremely simple, low-cost structure without considering, for example, the material of the casing 12.

Moreover, according to the LED light-emitting device 10 of the first embodiment, the light component exiting from the wall surface of the LED chip 11 towards the mounting surface is reflected on the border surface 18 between the first translucent member 13 and the second translucent member 14; therefore, the light component reliably enters from the first translucent member 13 into the second translucent member 14, and reducing the light absorbed by the casing 12 can increase the light output.

Then according to the LED light-emitting device 10 of the first embodiment, in the light component exiting from the wall surface of the LED chip 11 towards the mounting surface, the angle of incidence on the border surface 18 between the first translucent member 13 and the second translucent member 14 is equal to or larger than the critical angle; therefore, the total reflection of the light component on the border surface 18 can reduce the light absorbed by the casing 12 and increase the light output.

Further, the LED light-emitting device 10 of the first embodiment includes: the first translucent member 13 set on the front surface of the casing 12; and the second translucent member 14 which has the higher refraction index than that of the first translucent member 13 and which is set on the top surface of the first translucent member 13, and the light component from the LED chip 11 is reflected on the border surface 18 between the first translucent member 13 and the second translucent member 14; therefore, the light component exiting from the wall surface of the LED chip 11 towards the mounting surface enters from the first translucent member 13 into the second translucent member 14, and therefore reducing the light absorbed by the casing 12 can increase the light output.

In addition, according to the LED light-emitting device 10 of the first embodiment, the LED chip 11 is molded with the first translucent member 13 and the second translucent member 14 and thus firmly fixed without dislocation.

Furthermore, according to the LED light-emitting device 10 of the first embodiment, the second translucent member 14 has the same refraction index as the LED chip 11; therefore, the light from the LED chip 11 can efficiently be used.

Then, according to the LED light-emitting device 10 of the first embodiment, the members used for the first translucent member 13 and the second translucent member 14 have the optical property such that the light transmittance in the thickness of 2 mm is 85% or above in *a* wavelength range of 400 nm to 860 nm; therefore, the LED light-emitting device 10 can be manufactured with ease and cost advantages.

Then, according to the LED light-emitting device 10 of the first embodiment, the LED chip 11 is a blue LED that emits a blue light; therefore, *it can* be easily accessible and can be manufactured with cost advantages.

### (Second Embodiment)

Next, an LED light-emitting device according to a second embodiment of the present invention will be described.
In the embodiments described below, components overlapping with those of the first embodiment described above and functionally same components will be provided with the same numerals or corresponding numerals in the figures and thus their description will be simplified or omitted.

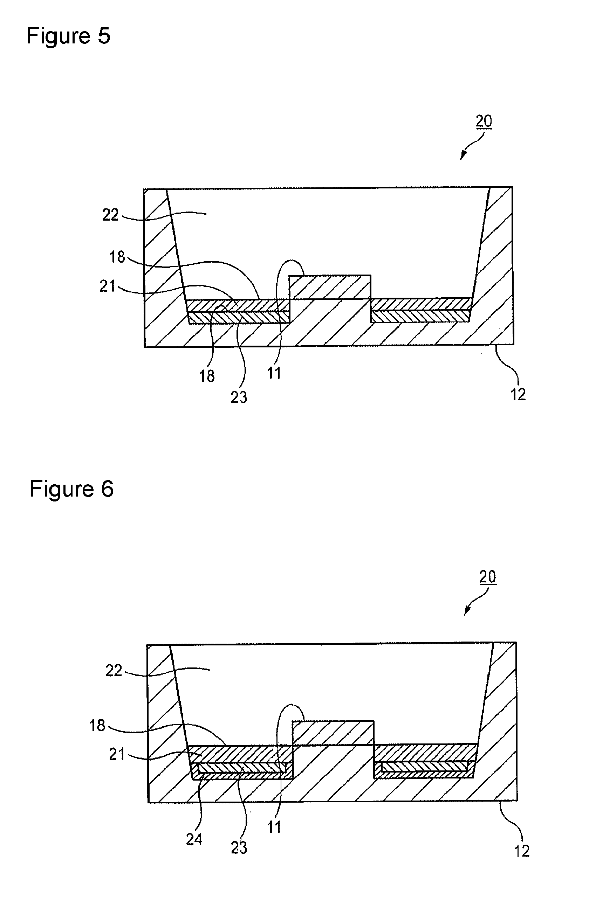

As shown in Fig. 5, the LED light-emitting device 20 according to the second embodiment of the present invention includes: the LED chip 11; the casing 12 on which the LED chip 11 is mounted; a first translucent member 21 and a second translucent member 22 which have different refraction indexes; and a high reflection member 23.
The high reflection member 23 reflects a light component whose angle of incidence on the first translucent member 21 does not exceed a critical angle.
Therefore, the light component incident on the first translucent member 21 without exceeding the critical angle is reflected by the high reflection member 23, which can therefore increase a reflection ratio.

For the high reflection member 23, a member with a high reflection ratio, for example, metal of a white resist or silvery-white type is selected. At this point, glass is applicable to the first translucent member 21.
Therefore, since the first translucent member 21 is of glass, moisture, a sulfur component, a gas component, etc. contributing to deterioration of the high reflection member 23 do not penetrate through the first translucent member 21, which can therefore prevent the deterioration of the high reflection member 23.

Moreover, after subjecting the first translucent member 21 of glass to mirror finishing, the high reflection member 23 can be applied to the second translucent member 22 and set in the casing 12.
Therefore, flatness of the high reflection member 23 increases, which can increase reflection efficiency.

As shown in Fig. 6, silver can be used for the high reflection member 23. In the case where the silver is used for the high reflection member 23, the silver easily responds to a different component such as sulfur, and thus the surroundings of the silver is coated with a protective film 24.
Therefore, the application of silver to the first translucent member 21 of glass and further coating silver with the protective film 24 for usage can prevent chemical response of the silver.
At this point, titanium or tungsten is selected for the protective film 24.
Therefore, the use of titanium or tungsten for the protective film 24 can reliably prevent the chemical response of the silver.

According to the LED light-emitting device 20 of the second embodiment, the light component incident on the first translucent member 21 without exceeding the critical angle is reflected by the high reflection member 23, which can therefore increase the reflection ratio.

According to the LED light-emitting device 20 of the second embodiment, the first translucent member 21 is of glass, the moisture, the sulfur component, the gas component, etc. contributing to the deterioration of the high reflection member 23 do not penetrate through the first translucent member 21, which can therefore prevent the deterioration of the high reflection member 23.

According to the LED light-emitting device 20 of the second embodiment, after subjecting the first translucent member 21 of glass to the mirror finishing, the high reflection member 23 can be applied to the first translucent member 21, and they can be set in the casing 12; therefore, the flatness of the high reflection member 23 increases, which can increase the reflection efficiency.

Further, according to the LED light-emitting device 20 of the second embodiment, silver is applied to the first translucent member 21 of glass and silver is further coated with the protective film 24, which can therefore prevent the chemical response of the silver.

In addition, according to the LED light-emitting device 20 of the second embodiment, the use of titanium or tungsten for the protective film 24 can reliably prevent the chemical response of the silver.

### (Third Embodiment)

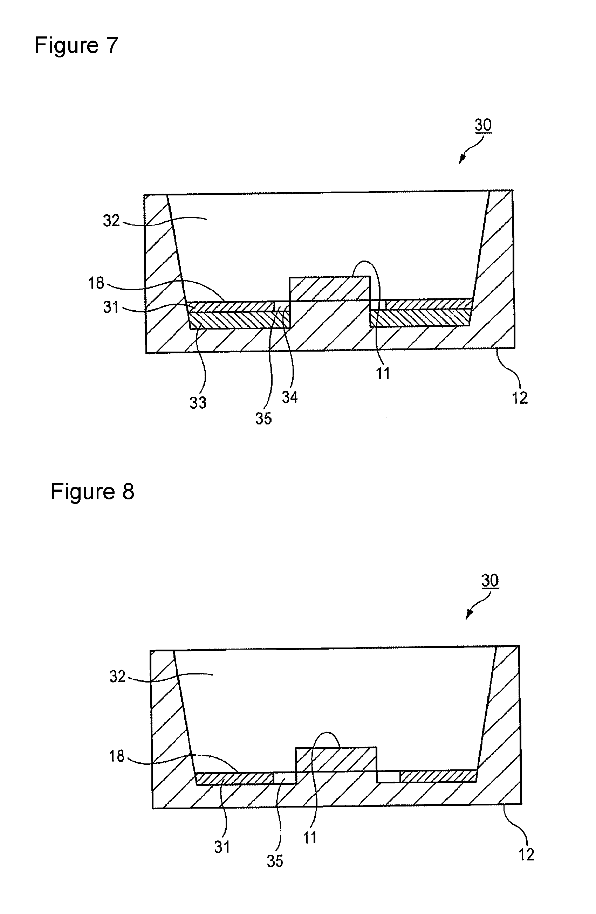

Next, an LED light-emitting device according to a third embodiment of the present invention will be described.
As shown in Fig. 7, the LED light-emitting device 30 according to the third embodiment of the present invention includes: the LED chip 11; the casing 12 on which the LED chip 11 is mounted; a first translucent member 31 and a second translucent member 32 which have different refraction indexes; and a high reflection member 33.

The first translucent member 31 may cover a top surface of the LED chip 11 by any chance when the first translucent member 31 is applied to the surroundings of the LED chip 11. The LED chip 11 is usually a member with a high refraction index in which GaN is 2.0 or above, and if its refraction index is higher than that of the first translucent member 31, performance in taking out light from the LED chip 11 is unsatisfactory. Thus, a gap 34 is provided between the first translucent member 31 and the LED chip 11.

Then the LED light-emitting device 30 has the high reflection member 33 set in the gap 34. A ratio of a light component which is incident on the first translucent member 31 at the surroundings of the LED chip 11 and which does not exceed a critical angle is large in many cases, and thus little reflected on a border surface 18 between the first translucent member 31 and the second translucent member 32, which is therefore not influenced by the gap 34.

At this point, as shown in Fig. 8, in the LED light-emitting device 30, the high reflection member 33 can be set only at the surroundings of the LED chip 11.

According to the LED light-emitting device 30 of the third embodiment, the ratio of the light component which is incident on the first translucent member 31 at the surroundings of the LED chip 11 and which does not exceed the critical angle is large in many cases, and is little reflected on the border surface 18 between the first translucent member 31 and the second translucent member 32; therefore, setting the high reflection member 33 in the gap 34 can improve reflection efficiency.

### (Fourth Embodiment)

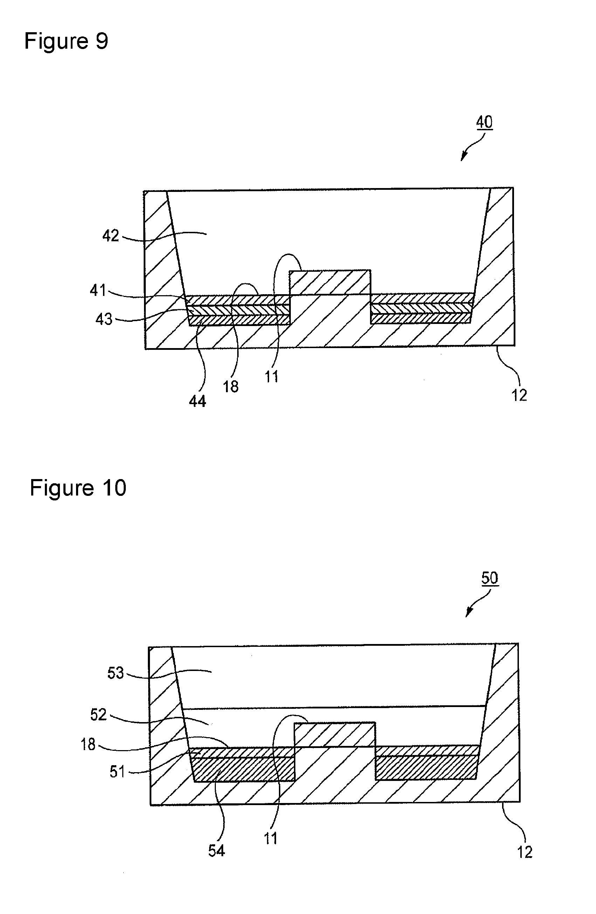

Next, an LED light-emitting device according to a fourth embodiment of the present invention will be described.
As shown in Fig. 9, the LED light-emitting device 40 according to the fourth embodiment of the present invention includes: the LED chip 11; the casing 12 on which the LED chip 11 is mounted; a first translucent member 41 and a second translucent member 42 which have different refraction indexes; a high reflection member 43; and a high heat resisting member 44.

The high heat resisting member 44 has a characteristic of 1W/mK and is arranged between the casing 12 and the high reflection member 43.
Deterioration of the high reflection member 43 is facilitated by heat transferred to the casing 12 following heat generation of the LED chip 11, thus resulting in a decreased reflection ratio.
Thus, the LED light-emitting device 40 absorbs, by the high heat resisting member 44, the heat transferred to the casing 12.
Therefore, setting a high heat resisting member of 1w/mK or below between the high reflection member 43 and the casing 12 can suppress the heat transferred to the high reflection member 43 at a minimum, which can suppress a decrease in light output following the heat generation.

According to the LED light-emitting device 40 of the fourth embodiment, setting the high heat resisting member 44 having a characteristic of 1w/mK or below between the high reflection member 43 and the casing 12 can suppress the heat transferred to the high reflection member 43 at a minimum, which can suppress the decrease in the light output following the heat generation.

### (Fifth Embodiment)

Next, an LED light-emitting device according to a fifth embodiment of the present invention will be described.
As shown in Fig. 10, the LED light-emitting device 50 according to the fifth embodiment of the present invention includes: the LED chip 11; the casing 12 on which the LED chip 11 is mounted; a first translucent member 51; a second translucent member 52 having a refraction index larger than that of the first translucent member 51; a third translucent member 53 having a refraction index larger than 1 and smaller than that of the second translucent member 52; and a high reflection member 54.

Use of a member with a high refraction index for the second translucent member 52 contributes to a cost increase, and due to a large difference in refraction index from the air, efficiency in light take-out into the air from the second translucent member 52 deteriorates. Thus, an amount of the second translucent member 52 used is reduced and the third translucent member 53 having the refraction index between that of the air and that of the second translucent member 52 is set above the second translucent member 52.
Therefore, application of the third translucent member 53 can improve the light take-out efficiency, and the third translucent member 53 is not a member with a large refraction index, which can therefore reduce member costs.

According to the LED light-emitting device 40 of the fourth embodiment, the application of the third translucent member 53 can improve the light take-out efficiency, and the third translucent member 53 is not a member with a large refraction index, which can therefore reduce the member costs.

### (Sixth Embodiment)

Next, an LED light-emitting device according to a sixth embodiment of the present invention will be described.
As shown in Fig. 11, the LED light-emitting device 60 according to the sixth embodiment of the present invention includes: the LED chip 11; the casing 12 on which the LED chip 11 is mounted; a first translucent member 61; a second translucent member 62 having a refraction index larger than that of the first translucent member 61; a high reflection member 63; and a phosphor 64 set inside the second translucent member 62.

The phosphor 64 emits light of a wavelength different from a wavelength (blue color) of light emitted from the LED chip 11.
In the LED light-emitting device 60, when the blue light emitted from the LED chip 11 is transmitted through inside of the second translucent member 62, a part of the light hits the phosphor 64 to be thereby converted into a yellow light to be taken out, so that the blue light and the yellow light are mixed together to provide white light.

At this point, the yellow light exiting from the phosphor 64 is completely diffused and thus radiated, and when an angle of incidence on the first translucent member 61 exceeds a critical angle, the yellow light is totally reflected on the border surface 18 between the first translucent member 61 and the second translucent member 62, and when the angle of incidence does not exceed the critical angle, the yellow light is incident on the first translucent member 61 and reflected by the high reflection member 63.
Therefore, by the phosphor 64 set inside the second translucent member 62, light absorbed by the casing 12 can be suppressed, which permits a high output.

According to the LED light-emitting device 60 of the sixth embodiment, by the phosphor 64 set inside the second translucent member 62, the light absorbed by the casing 12 can be suppressed, which permits a high output.

The LED light-emitting device of the present invention is not limited to the embodiments described above, but may be, for example, modified or improved as appropriate.

### [Description of Reference Numerals]

- 10, 20. 30, 40, 50, 60: LED light-emitting device
- 11: LED chip
- 12: Casing
- 13, 21, 31, 41, 51, 61: First translucent member (translucent member)
- 14, 22, 32, 42, 52, 62: Second translucent member (translucent member)
- 18: Border surface
- 23, 35, 54, 63: High reflection member
- 34: Gap
- 44: High heat resisting member
- 53: Third translucent member (translucent member)
- 64: Phosphor

## Claims

1. An LED light-emitting device comprising:
at least one LED chip;
a casing having the LED chip mounted thereon; and
two or more kinds of translucent members set in the casing, the translucent members having different refraction indexes, wherein
light radiated from the LED chip to the casing is reflected on a border surface between the translucent members.

2. The LED light-emitting device according to claim 1, wherein
light exiting from a wall surface of the LED chip towards a mounting surface of the LED chip is reflected on the border surface between the translucent members.

3. The LED light-emitting device according to claim 2, wherein
the light exiting from the wall surface of the LED chip towards the mounting surface of the LED chip has an angle of incidence on the border surface between the translucent members equal to or larger than a critical angle.

4. The LED light-emitting device according to claim any one of claims 1 to 3, wherein
the translucent members include: the first translucent member set on a front surface of the casing; and the second translucent member which has the refraction index higher than the refraction index of the first translucent member and which is set on a top surface of the first translucent member, and the light from the LED chip is reflected on the border surface between the first translucent member and the second translucent member.

5. The LED light-emitting device according to any one of claims 1 to 4, wherein
the LED chip is molded with the translucent member.

6. The LED light-emitting device according to claim 5, wherein
the refraction index of the translucent member is equal to a refraction index of the LED chip.

7. The LED light-emitting device according to any one of claims 1 to 6, wherein
a high reflection member is set between the translucent member and the casing.

8. The LED light-emitting device according to any one of claims 3 to 7, wherein
the translucent member is of glass.

9. The LED light-emitting device according to claim 8, wherein
the high reflection member is applied to the glass subjected to mirror finishing and set in the casing.

10. The LED light-emitting device according to claim 9, wherein silver is applied to the glass and a high reflection member obtained by coating silver with a protective film is used.

11. The LED light-emitting device according to claim 10, wherein
at least either of titanium and tungsten is used for the protective film.

12. The LED light-emitting device according to any one of claims 3 to 11, wherein
a gap is provided at a front surface of the casing at surroundings of the LED chip, and the high reflection member is set in the gap.

13. The LED light-emitting device according to any one of claims 8 to 11, wherein
a high heat resisting member of 1W/mK or below is set between the high reflection member and the casing.

14. The LED light-emitting device according to any one of claims 1 to 13, wherein
a translucent member having a refraction index larger than 1 and smaller than the refraction index of the translucent member is set above the translucent member.

15. The LED light-emitting device according to any one of claims 1 to 14, wherein
the translucent member has a phosphor which is excited by the light exiting from the LED chip and which emits light of a wavelength different from a wavelength of the light exiting from the LED chip.

16. The LED light-emitting device according to any one of claims 1 to 15, wherein
a member used for the translucent member has a characteristic such that light transmittance in a thickness of 2 mm is 85% or above in a wavelength range of 400 nm to 860 nm.

17. The LED light-emitting device according to any one of claims 1 to 16, wherein
the LED chip emits a blue light.
